Europäisches Patentamt

European Patent Office

Office européen des brevets

(11) Publication number: **0 196 567**
**B1**

# EUROPEAN PATENT SPECIFICATION

(45) Date of publication of the patent specification:
31.10.90

(51) Int. Cl.⁵: **G01N 29/00**

(21) Application number: **86103856.0**

(22) Date of filing: **21.03.86**

(54) Apparatus and method for monitoring the operating condition of a drill bit.

(30) Priority: **05.04.85 US 720340**

(43) Date of publication of application:
**08.10.86 Bulletin 86/41**

(45) Publication of the grant of the patent:
**31.10.90 Bulletin 90/44**

(84) Designated Contracting States:
**DE FR GB**

(56) References cited:
**EP-A- 0 090 893**
**EP-A- 0 093 558**
**EP-A- 0 119 680**
**WO-A-82/03589**
**GB-A- 2 136 125**
**US-A- 4 088 899**

(73) Proprietor: **International Business Machines
Corporation, Old Orchard Road, Armonk, N.Y. 10504(US)**

(72) Inventor: **Wen, Sheree Hsiao-Ru, 1355 Quarry Drive,
Mohegan Lake New York 10547(US)**

(74) Representative: **Atchley, Martin John Waldegrave, IBM
United Kingdom Limited Intellectual Property
Department Hursley Park, Winchester Hampshire
SO21 2JN(GB)**

## Description

This invention relates to monitoring the condition of a drill bit in an automatic drilling machine and has a particular application in detecting the depth within a work piece to which a drill bit has penetrated and changing the operation of the drill bit accordingly.

In computer controlled automated mechanical drilling operations it is necessary to ensure that the drill bit remains sharp and unbroken throughout the drilling operation. This is especially important in the drilling of printed circuit boards. In the manufacturing of single and multilayer printed circuit boards, holes are drilled through the board to accommodate the electrical connections required for the circuits. In many manufacturing operations, the number of holes drilled can range from 4,000 to 10,000. Generally, for drilling a large number of holes in the circuit boards, a drilling machine is used having a plurality of spindles so that a number of holes can be drilled simultaneously. The large total volume of the holes being drilled requires that the drill bits be of a very small diameter. Currently, the smallest drill bit being used is approximately 0.406 mm (0.016 inch) in diameter.

The use of these very fine drill bits causes the bits to become blunt or broken very easily during the drilling operation. Even if the machines are automatically controlled, the drilling operation cannot be stopped immediately and a broken or blunt drill bit will continue to spin and damage the boards. Any hole drilled with a blunt or broken drill bit will be defective. This is not acceptable in the manufacture of circuit boards where accuracy is required. The defective holes must be reworked, resulting in a significant delay and expense. Frequently, proper reworking cannot be accomplished and an entire set of boards must be rejected.

Furthermore, in the manufacturing of multilayer circuit boards, it is often necessary to drill through only to certain intermediate layers for the connections of the electrical circuits. However, heretofore there has not been available an efficient and accurate system for drilling multilayer boards to a predetermined depth. Thus, manufacturers are normally forced to drill through all the layers. In one approach to the problem, the machine is controlled by an operator to drill for a preselected time at a predetermined speed. This practice has been found to be unsuccessful because the drilling speed varies as the drill bit progresses through inhomogeneous mediums. In addition, the operator must know precisely when the drilling commences and what the drilling speed is. Hence, very often the machine drills through more layers than is needed requiring additional electrical connections and unnecessary costs.

Prior art systems for monitoring machine tools include the detection of noise associated with the machine operation.

One such system is disclosed in United States Patent Specification A-4,413,507 wherein noise emission signals associated with the linear cutting operation of a tool are compared with a standard signal to determine when the tool has become worn.

If the level of noise detected exceeds a threshold level an output signal indicates that the cutting tool has become blunt. The apparatus disclosed does not address the problem of the detection of the drill bit condition in a drilling machine.

United States Patent Specification A-3,486,375 discloses an apparatus for determining the lithologic condition of underground rock formations. A transducer is provided on the drilling apparatus that transmits electrical signals to the surface in accordance with the acoustic vibrations produced by the drilling machine. The signals are recorded on a strip chart recorder where the different amplitude levels of the output signal can be observed to determine which type of rock formation is being drilled. The apparatus is not suitable for determining the operating condition of a drill bit.

The object of the present invention is to provide an improved apparatus and method for monitoring the operating condition of a drill bit.

The invention relates to apparatus for monitoring the operating condition of a drill bit comprising a transducer located adjacent to the drill bit and adapted to generate an output signal representing the acoustic signature of the drill bit when in operation on a work piece, a reference source generating a reference signal representing a reference acoustic signature, comparison means for comparing the parameters of the output signal with the parameters of the reference signal in order to monitor the operating condition of the drill bit, and control means responsive to the output from the comparison means for changing the operation of said drill bit when the parameters of the output signal and the reference signal have a predetermined relationship. Such an apparatus is known from EP-A1 0 119 680.

Appartus in accordance with the invention is characterised in that the reference signal represents the acoustic signal of the drill bit when drilling through different portions of the work piece and the comparison means supplies the control signal to the control means to stop the operation of the drill bit when the parameters of the output signal are equal to the parameters of the portion of the reference signal representing a selected acoustic signature so as to stop the drill bit when it has penetrated to a predetermined portion of the work piece corresponding to the selected acoustic signature.

The invention also relates to a method of monitoring the operating condition of a drill bit using apparatus as above.

The present invention provides an apparatus and method for monitoring the depth of a drilling operation. In the drilling of single layer or multilayer circuit boards, where single or multiple spindle drilling machines are used, according to one embodiment of the invention a detector is provided to monitor the condition of the drill bits in the drilling machine. The detector includes a plurality of acoustic detecting transducers attached to the machine for producing an electrical output signal in response to the vibrations of each of the drill bits. The vibrations will have a particular acoustic signature depending on the condition of the drill bit and the medium being drilled. Each output signal is an electric representation of the acoustic signature of the associated drill bit produced during drilling. Each acoustic signature is represented by an output signal with a waveform having a particular amplitude and frequency. A control unit simultaneously compares each of the output signals with a reference signal stored in the control unit. The reference signal represents the acoustic signature of a normal drill bit. The acoustic signatures detected during the drilling of a workpiece are compared with the reference signature to detect changes in each acoustic signature from the reference signature. An improper drill condition exists when an output signal has an amplitude lower than the amplitude of the reference signal. In addition, a change in the frequency of the output signal from the reference frequency will also indicate an improper drill condition. A display having individual indicating lights is provided to indicate to the operator of the machine that a particular drill bit is blunt or broken. A computer may be included to automatically stop the operation of the particular spindle that has the blunt or broken drill bit so that the bit can be replaced before damaging the circuit board.

In another embodiment of the present invention, the apparatus can be utilized to monitor the depth to which a drill bit has penetrated into a multilayered workpiece in order to be able to drill to any desired layer. An acoustic transducer is connected to the top layer of the circuit board and produces a sequence of output signals in response to the vibration caused by drilling through each of the layers. Each particular type of layer produces an output signal representing a different acoustic signature.

A control unit has stored within its memory reference signals equal to the known acoustic signature for each type of layer. The control unit compares the acoustic signature represented by the output signals to the reference signal and counts the number of occurrences of the acoustic signature for each type of layer. The control unit can be programmed to stop the drilling operation upon reaching a predetermined number of acoustic signatures for any particular layer. Thus, the apparatus can be used to drill to any predetermined level in order to make the proper interconnections for the electrical circuits.

Hence, using the apparatus and method according to the present invention results in very accurate drilling utilizing very fine drill bits, such as within a 0.254 to 0.305 mm (0.010 to 0.012 inch) diameter. In addition, the smaller drill bits allow for more connections to the electrical circuits thereby increasing the circuit density of the boards. Only the layers to be interconnected are drilled by the apparatus thereby eliminating the problem of needlessly drilling through all the layers of the circuit board.

Furthermore, a computer can be provided for storing a particular sequence of signals in accordance with the known multilayer configuration. The computer can compare the actual sequence of output signals with the reference sequence to determine if all the proper layers are provided within the circuit board, Thus, previous process steps of manufacturing the circuit boards can be monitored.

In order that the invention may be more readily understood an embodiment will now be described with reference to the accompanying drawings, in which:-

Figure 1 is a block diagram of the apparatus in accordance with the present invention,

Figure 2 is a sketch of a multiple spindle drilling machine for drilling a multilayer circuit board which includes apparatus in accordance with the invention,

Figure 3 is a block diagram of the control unit for the apparatus according to the present invention,

Figure 4 is a diagram of an oscilloscope trace of the output signal produced by a transducer in the apparatus of Figure 1 as seen before the drilling operation,

Figure 5 is a diagram of an oscilloscope trace of the output signal as seen during normal drilling,

Figure 6 is a diagram of an oscilloscope trace of the output signal as seen with a broken drill bit,

Figure 7 is a diagram of a cross-section of a multilayer circuit board, and

Figure 8 is a diagram of an oscilloscope trace showing the output signal of the transducer when drilling through the circuit board of Figure 7.

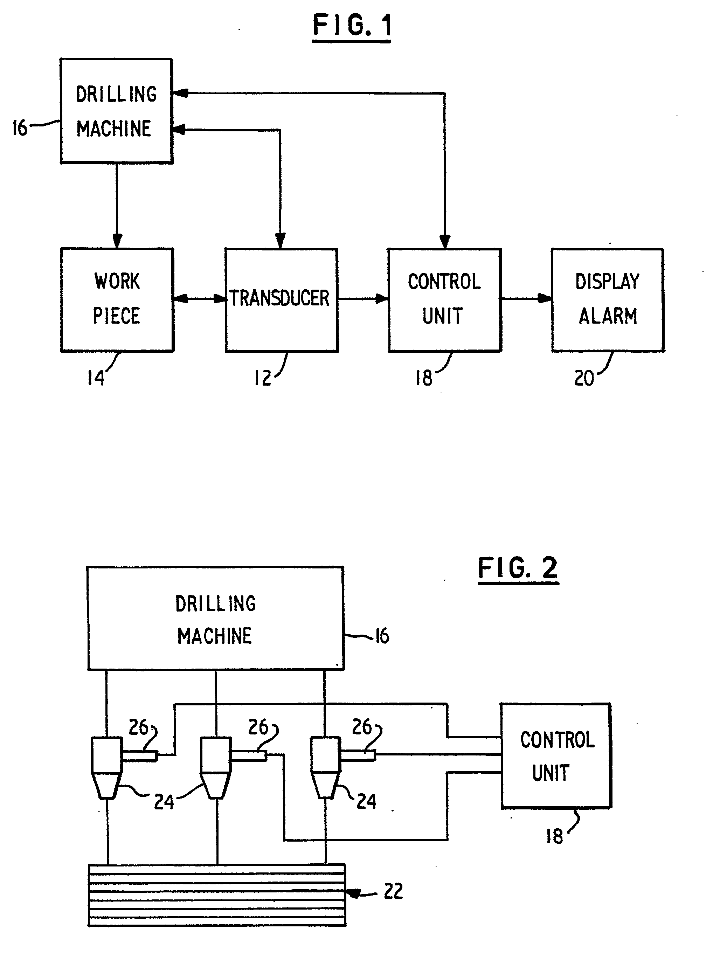

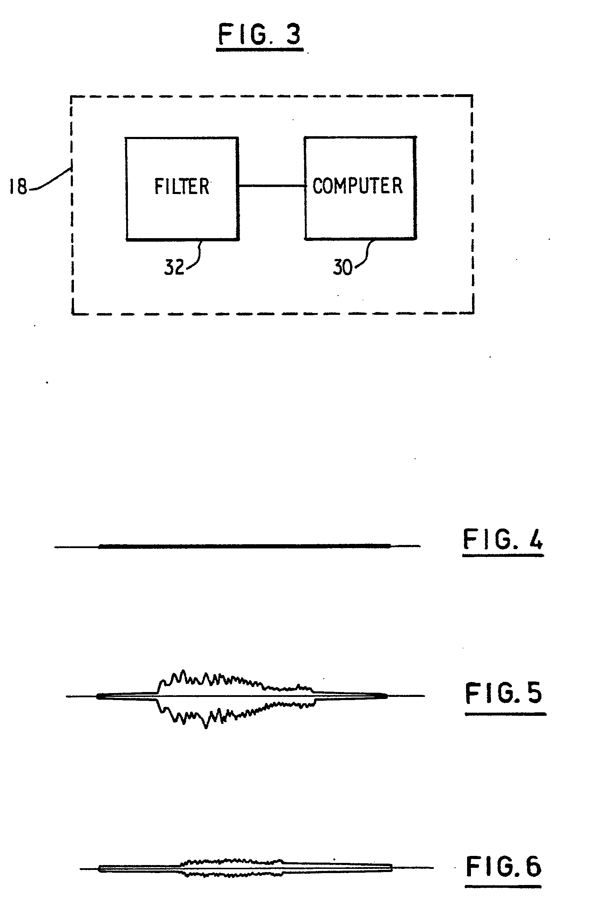

Referring now to the drawings, Figure 1 shows a block diagram of an illustrative embodiment of apparatus according to the present invention. The apparatus includes a transducer 12 for producing electrical output signals in response to vibrations caused by a drilling operation. The transducer 12 may be connected either to a workpiece 14 on which the drilling operation is being performed or to any part of a drilling machine 16. The drilling machine includes one or more drill bits for performing the drilling operation. The transducer 12 may be connected to the spindle of one of the drill bits or to the work piece adjacent to the region where the drill bit is to operate. The transducer 12 converts the vibrations into electrical signals and this output of the transducer is fed to a control unit 18. The control unit 18 is designed to perform the various functions of the apparatus. The control unit is programmed to compare the output signal from the transducer 12 with a reference signal to produce a signal activating a display or alarm 20 when an improper condition of the drill bit with which it is associated is detected. The control unit 18, as shown in Figure 3, also includes a computer 30 and a feedback connection to the drilling machine 16 to automatically stop the machine when an improper drill bit condition is detected.

The electrical output signal from the transducer 12 will be a waveform of a particular amplitude and frequency dependent on the condition of the associated drill bit. This waveform represents the acoustic signature of the drill bit. The reference signal represents an established acoustic signature determined from normal drilling with a drill bit in proper condition. The output signal from the transducer 12 and the reference signal are continuously compared by the control unit 18. During normal drill bit conditions, the output signal will be equal to the reference signal. When the drill bit becomes blunt or broken, the output signal will vary from the reference signal. The blunt or broken drill bit will produce, at the output of the transducer 12, an output signal with a waveform having an amplitude or frequency differing from those of the reference signal. Generally, the output signal will have an amplitude lower than the established reference signal. This amplitude or frequency difference is then detected by the control unit 18 and an alarm or display is activated. In computer controlled operations, the drilling machine will be automatically stopped to permit the blunt or broken drill bit to be replaced. Thus, the reworking or rejection of the work piece 14 is greatly reduced by the present invention.

The apparatus of the present invention is especially well suited for use in the drilling of multilayer printed circuit boards. Multilayer boards are drilled by a drilling machine having a plurality of spindles and drill bits for drilling a plurality of holes simultaneously. Figure 2 is a sketch showing a multilayer printed circuit board 22 being drilled by a drilling machine 16 having a plurality of spindles and drill bits 24. An acoustic transducer 26 is connected to each of the spindles 24 for simultaneously converting into electrical output signals vibrations from each spindle caused by vibrations of the associated drill bit as it performs a drilling operation in the board 22 and transmitting these output signals to the control unit 18. These output signals represent the acoustic signatures of the drill bits. In this arrangement, it is preferred that a separate transducer be connected to each spindle or drill bit 24. However, the apparatus will function with only one transducer 26 connected to the circuit board 22 if the control unit 18 is designed to discriminate between the intensities of the signals resulting from the vibrations of each of the drill bits depending upon the distance of each drill bit from the transducer.

The or each transducer 26 may be any type of acoustic detection device such as a piezoelectric crystal, microphone, or phonographic cartridge. Furthermore, the acoustic contact between the transducer 26 and each spindle 24 or the board 22 may be by gas, grease, mechanical coupling or a liquid or by an acoustic rod which can transfer the acoustic signals from the board, spindle, or drilling machine to the transducer.

In the arrangement shown in Figure 2, the control unit 18 will simultaneously compare the output signal from each of the spindles 24 with the reference signal. If the acoustic signature of one or more of the drill bits varies from the reference signature by a predetermined amount, the control unit 18 will stop the drilling machine and actuate the display or alarm 20. Alternatively, in computer controlled operations, the computer can be programmed to stop only each spindle having a blunt or broken drill bit, while the other spindles continue to drill, thereby saving valuable work time. Parallel signal processing would be used in order to discriminate between the acoustic signatures of the spindles and only stop each spindle having a blunt or broken drill.

Figures 4, 5 and 6 are diagrams of oscilloscope traces of transducer output signals obtained from the operation of the apparatus described above. A 300 khz piezoelectric transducer 26 was used and a quartz rod was employed to establish acoustic contact between the transducer and the circuit board 22. Figure 4 shows the oscilloscope trace before drilling. Figure 5 shows the trace obtained during the drilling process employing an undamaged drill bit. Figure 6 shows the oscilloscope trace when the drill bit had a 0.051 mm (0.002 inch) chip from the tip. As can be seen by comparing Figures 5 and 6, the damaged drill bit shows an evident decrease in acoustic signature amplitude.

To facilitate the detection of this amplitude decrease, the control unit 18, as shown in Figure 3, includes a filter means 32 for filtering out noise from the environment such as human talking, floor vibration, or movement of the machine itself. A band pass filter is used since the above-mentioned noise will generally be in a low frequency range. In addition, there are also high frequency noises that should be filtered out. The filter can be designed to permit the detection of only a particular window or range of frequencies to filter out both low and high frequency noises.

The drill bit condition detector provided by the apparatus described above minimises and may largely eliminate the need for visual inspection of the drill bit during the drilling process. It eliminates the need for reworking holes that were improperly drilled between a drill bit failure and a detection of the broken drill bit by periodic inspection. Costs and wastage due to the reworking of printed circuit boards and other work pieces drilled with defective bits will be greatly reduced.

In computer controlled operations, the apparatus will permit real time monitoring of the interval between drill bit failures. It is then possible to measure and maintain statistics on drill bit lifetimes. A defective batch of drill bits can then be detected at an early stage due to the difference in life time statistics from the established norm.

In addition to detecting blunt or broken drill bits, abnormal acoustic signatures may also indicate drill bit misalignment or misregistration, incorrect drilling speed or incorrect rotating speed. The control unit 18 and the display 20 can be modified accordingly to warn the operator of these different abnormal conditions.

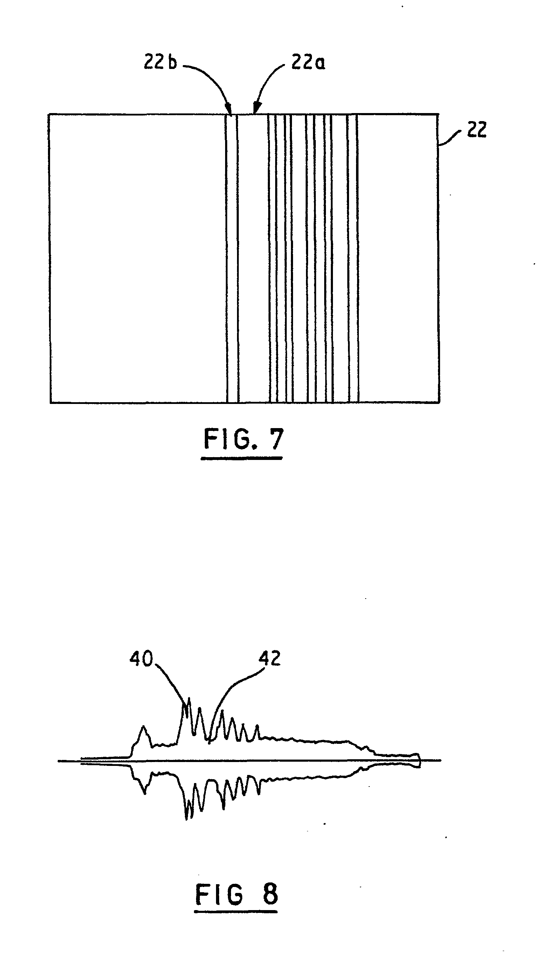

The apparatus described above can also be used to monitor the depth of drilling through a workpiece. This is especially useful in drilling multilayer printed circuit boards. Figure 7 is a cross section of a typical multilayer printed circuit board 22 having alternate layers of epoxy-glass 22a and copper 22b. In this arrangement, transducer 12 is attached to the top layer of the circuit board 22. The transducer 12 will produce an electrical output signal in response to the vibrations caused by drilling through each layer of the circuit board 22 using a drill bit. The acoustic signature of the drill bit, as represented by this electrical output signal, will depend upon the material of the particular layer being drilled. As stated above, the acoustic signature will be represented by a waveform of a particular amplitude and frequency and this will be different for each layer being drilled through. The output signal will therefore include a sequence of waveforms, where each of the waveforms represent the acoustic signature of the drill bit for the layer being drilled. For the multilayer printed circuit board 22 shown in Figure 7 having layers of two different materials, there will be two distinct acoustic signatures reflected in two waveforms each having different amplitudes and frequencies. Thus, it can easily be determined which particular layer 22a, 22b the drill bit is drilling through by a count of the number of occurrences of the waveforms representing the acoustic signature for each layer.

The control means 18 compares the waveforms of the output signal with a reference signal for each layer and counts the number of occurrences of the waveform for each layer. The count may be of the number of occurrences of the particular amplitude level or of the particular frequency for each layer. The control unit 18 can then automatically stop the machine upon reaching the predetermined count of waveform occurrences for a particular layer.

Figure 8 shows the oscilloscope trace of the transducer output signal when using a 0.406 mm (0.016 inch) drill bit to drill through the circuit board 22 shown in Figure 7. The acoustic signal was detected by a piezoelectric transducer at 300 kHz which was attached to the circuit board 22 on its upper face, the face which is first in contact with the drill bit. The acoustic signature pattern shows a high amplitude 40 during the period in which the drill bit is passing through each epoxy-glass layer 22a and a low amplitude 42 during the period in which the drill is passing through each copper layer 22b.

In operation, if it is desired to drill to the top of a particular intermediate layer, such as a copper layer, in a multilayer circuit board, the layer number is entered into the computer control unit 18. The computer control unit 18 is thereby externally programmed to detect the arrival of the drill bit at this particular layer by counting the number of amplitude levels representative of successive copper layers. Upon detecting the change in the acoustic pattern for the desired layer number, the computer can then instruct the drilling machine to cease operation immediately. If, alternatively, it is desired to drill through a particular copper layer, the output change in amplitude can be used to detect the penetration through the copper layer and the computer can likewise instruct the drilling machine to cease operation at that instant. Similarly, changes in the frequency of the output signal can be counted by the computer to control the drilling depth. It is therefore possible to employ acoustic signature signals to accomplish drilling through to any predetermined depth within a multilayer circuit board.

The apparatus described makes it possible to drill holes into a multilayer circuit board to any predetermined depth within the board in a more accurate and controlled way. The apparatus creates the possibility of layering the circuits which can be accessed for connection to a particular chip on the boards for proper interconnection of the circuits. Thus, there is no longer a need to drill through all the layers of a circuit board, thereby eliminating unnecessary connections and decreasing costs. The apparatus described permits the interconnection of only the layers that are required to be connected. The combination of the blunt or broken drill bit condition detector and the drill bit depth detector into one bit detection apparatus would enable the use of very fine drills, within the 0.254 to 0.305 mm (0.01 to 0.012 inch) diameter range. The use of these smaller drills would allow the interconnection of more circuits thereby increasing the circuit density of the circuit boards.

Furthermore, in carrying out the drilling operation in a constant and predetermined way, the change in amplitude of the transducer output signal as the drill bit progresses through the various layers in a multilayer circuit board will yield the spacial sequence of the layers within the board. By comparing the detected spacial sequence from the actual operation with a theoretical sequence developed on the basis of the internal geometry of the multilayer circuit board, it is possible to determine in real time whether there is any misregistration between the work piece and the drill bit. This misregistration might consist of improper orientation or alignment of the workpiece or an improper alignment of the drill bit. In addition, the proper geometry of the board can be tested by matching the sequence with the reference sequence. Thus, previous steps in the manufacturing of the circuit board can be tested. The computer can be modified to provide signals on the display indicating the type of problem detected.

**Claims**

1. Apparatus for monitoring the operating condition of a drill bit (24) comprising
a transducer (26) located adjacent to said drill bit and adapted to generate an output signal representing an acoustic signature of said drill bit when in operation on a work piece (22),
a reference source generating a reference signal representing a reference acoustic signature,
comparison means (18) for comparing the parameters of said output signal with the parameters of said reference signal in order to monitor the operating condition of said drill bit, and
control means (18) responsive to the output from said comparison means for changing the operation of said drill bit when the parameters of said output signal and said reference signal have a predetermined relationship, characterised in that
said reference signal represents the acoustic signal of said drill bit when drilling through different portions (22a, 22b) of said work piece and said comparison means supplies said control signal to said control means to stop the operation of said drill bit when the parameters of said output signal are equal to the parameters of the portion of said reference signal representing a selected acoustic signature so as to stop said drill bit when it has penetrated to a predetermined portion of said work piece corresponding to said selected acoustic signature.

2. Apparatus as claimed in claim 1 characterised in that said reference signal represents the acoustic signal of said drill bit when drilling through different layers (22a, 22b) of said work piece.

3. A method of monitoring the operating condition of a drill bit comprising generating an output signal representing the acoustic signature of said drill bit when in operation on a work piece,

generating a reference signal representing a reference acoustic signature,

performing a comparison operation for comparing the parameters of said output signal with the parameters of said reference signal in order to monitor the operating condition of said drill bit, and

changing the operation of said drill bit in response to the result of said comparison operation when the parameters of said output signal and said reference signal have a predetermined relationship, characterised in that

said reference signal represents the acoustic signal of said drill bit when drilling through different portions of said work piece and the operation of said drill bit is stopped when the parameters of said output signal are equal to the parameters of the portion of said reference signal representing a selected acoustic signature so as to stop said drill bit when it has penetrated to a predetermined portion of said work piece corresponding to said selected acoustic signature.

**Patentansprüche**

1. Gerät für die Überwachung des Betriebszustands eines Bohrers (24), enthaltend:

einen Meßwandler (26), an besagtem Bohrer angeordnet, und dafür ausgelegt, ein Ausgangssignal zu erzeugen, das eine akustische Kennzeichnung des besagten Bohrers in Betrieb auf einem Werkstück (22) darstellt,

eine Bezugsquelle, die ein Bezugssignal erzeugt, das eine akustische Bezugskennzeichnung darstellt,

Vergleichsmittel (18) zum Vergleichen der Parameter des besagten Ausgangssignals mit den Parametern des besagten Bezugssignals, um den Betriebszustand des besagten Bohrers zu überwachen, und Steuermittel (18), die auf den Ausgang von besagten Vergleichsmitteln ansprechen, um den Betrieb des besagten Bohrers zu ändern, wenn die Parameter des besagten Ausgangssignals und das besagte Bezugssignal eine vorgegebene Beziehung aufweisen, dadurch gekennzeichnet, daß

besagtes Bezugssignal ein akustisches Signal des besagten Bohrers darstellt, beim Bohren durch verschiedene Abschnitte (22a, 22b) des besagten Werkstücks, und besagtes Vergleichsmittel besagtes Steuersignal an besagte Steuermittel abgibt, um den Betrieb des besagten Bohrers zu unterbrechen, wenn die Parameter des besagten Ausgangssignals gleich den Parametern des Abschnitts des besagten Bezugssignals sind, die eine ausgewählte akustische Kennzeichnung darstellen, um den besagten Bohrer anzuhalten, wenn er bis in einen vorgegebenen Abschnitt des besagten Werkstücks eingedrungen ist, der der besagten akustischen Kennzeichnung entspricht.

2. Gerät gemäß Anspruch 1, dadurch gekennzeichnet, daß besagtes Bezugssignal das akustische Signal des besagten Bohrers darstellt, wenn er in verschiedenen Tiefen (22a, 22b) des besagten Werkstücks bohrt.

3. Verfahren der Überwachung des Betriebszustandes eines Bohrers, enthaltend:

die Erzeugung eines Ausgangssignals, das die akustische Kennzeichnung des besagten Bohrers im Betrieb an einem Werkstück darstellt,

Erzeugung eines Bezugssignals, das eine akustische Bezugskennzeichnung darstellt,

Bildung eines Vergleichs, in dem die Parameter des besagten Ausgangssignals mit den Parametern des besagten Bezugssignals verglichen werden, um den Betriebszustand des besagten Bohrers zu überwachen, und

Änderung des Betriebs des besagten Bohrers als Antwort auf das Ergebnis des besagten Vergleichs, wenn die Parameter des besagten Ausgangssignals und des besagten Bezugssignals eine vorgegebene Beziehung aufweisen, dadurch gekennzeichnet, daß

besagtes Bezugssignal das akustische Signal des besagten Bohrers beim Bohren in verschiedenen Abschnitten des besagten Werkstücks darstellt, und der Betrieb des besagten Bohrers unterbrochen wird, wenn die Parameter des besagten Ausgangssignals gleich den Parametern des Abschnitts des besagten Bezugssignals sind, das eine ausgewählte akustische Kennzeichnung darstellt, um besagten Bohrer anzuhalten, wenn er bis in einen vorgegebenen Abschnitt des besagten Werkstücks eingedrungen ist, der der besagten ausgewählten akustischen Kennzeichnung entspricht.

**Revendications**

1. Dispositif pour contrôler la condition de fonctionnement d'un foret (24), comprenant

un transducteur (26) situé au voisinage dudit foret et apte à produire un signal de sortie représentant une signature acoustique dudit foret lorsqu'il est en action sur une pièce à usiner (22),

une source de référence produisant un signal de référence représentant une signature acoustique de référence,

des moyens comparateurs (18) servant à comparer les paramètres dudit signal de sortie aux paramètres dudit signal de référence de manière à contrôler la condition de fonctionnement dudit foret, et

des moyens de commande (18) sensibles au signal de sortie desdits moyens comparateurs pour modifier le fonctionnement dudit foret lorsque les paramètres dudit signal de sortie et dudit signal de référence sont reliés par une relation prédéterminée, caractérisé en ce que

ledit signal de référence représente le signal acoustique dudit foret lors du perçage à travers différentes parties (22a, 22b) de ladite pièce à usiner, et lesdits moyens comparateurs envoient ledit signal de commande auxdits moyens de commande pour arrêter le fonctionnement dudit foret lorsque les paramètres dudit signal de sortie sont égaux aux paramètres de la partie dudit signal de référence représentant la signature acoustique sélectionnée de manière à arrêter ledit foret lorsqu'il a pénétré dans une partie prédéterminée de ladite pièce à usiner, qui correspond à ladite signature acoustique sélectionnée.

2. Dispositif selon la revendication 1, caractérisé en ce que ledit signal de référence représente le signal acoustique dudit foret lors du perçage à travers différentes couches (22a, 22b) de ladite pièce à usiner.

3. Procédé pour contrôler la condition de fonctionnement d'un foret, consistant à

produire un signal de sortie représentant une signature acoustique dudit foret lorsqu'il est en action sur une pièce à usiner,

produire un signal de référence représentant une signature acoustique de référence,

exécuter une opération de comparaison servant à comparer les paramètres dudit signal de sortie aux paramètres dudit signal de référence de manière à contrôler la condition de fonctionnement dudit foret, et

modifier le fonctionnement dudit foret en réponse aux résultats de ladite opération de comparaison lorsque les paramètres dudit signal de sortie et dudit signal de référence sont reliés par une relation prédéterminée, caractérisé en ce que

ledit signal de référence représente le signal acoustique dudit foret lors du perçage effectué dans différentes parties de ladite pièce à usiner, et le fonctionnement dudit foret est arrêté lorsque les paramètres dudit signal de sortie sont égaux aux paramètres de la partie dudit signal de référence représentant une signature acoustique sélectionnée de manière à arrêter ledit foret lorsqu'il a traversé une partie prédéterminée de ladite pièce à usiner, correspondant à ladite signature acoustique sélectionnée.

## FIG. 1

## FIG. 2

## FIG. 3

## FIG. 4

## FIG. 5

## FIG. 6

22b    22a

22

FIG. 7

40    42

FIG 8